(19)

Europäisches
Patentamt
European
Patent Office
Office européen
des brevets

(11) **EP 2 099 157 A1**

(12) **EUROPEAN PATENT APPLICATION**
published in accordance with Art. 153(4) EPC

(43) Date of publication:
    **09.09.2009 Bulletin 2009/37**

(21) Application number: **07764214.8**

(22) Date of filing: **12.07.2007**

(51) Int Cl.:
    **H04L 12/26** (2006.01)

(86) International application number:
    **PCT/CN2007/070286**

(87) International publication number:
    **WO 2008/031343 (20.03.2008 Gazette 2008/12)**

(84) Designated Contracting States:
    **AT BE BG CH CY CZ DE DK EE ES FI FR GB GR
    HU IE IS IT LI LT LU LV MC MT NL PL PT RO SE
    SI SK TR**

(30) Priority: **12.09.2006 CN 200610127522**

(71) Applicant: **Huawei Technologies Co., Ltd.
    Shenzhen, Guangdong Province 518129 (CN)**

(72) Inventors:
    • **JIN, Zhaoguo
      Shenzhen
      Guangdong 518129 (CN)**

    • **JIN, Longbao
      Shenzhen
      Guangdong 518129 (CN)**
    • **XU, Guijin
      Shenzhen
      Guangdong 518129 (CN)**
    • **TIAN, Yuzhou
      Shenzhen
      Guangdong 518129 (CN)**

(74) Representative: **Körber, Martin Hans et al
    Mitscherlich & Partner
    Patent- und Rechtsanwälte
    Sonnenstraße 33
    80331 München (DE)**

(54) **APPARATUS AND METHOD FOR DETECTING BRIDGED STATE OF SUBSCRIBER LINE**

(57) An apparatus and method for detecting a bridged state of a subscriber line is provided, in which the apparatus comprises: a line access unit for connecting with a subscriber line to be detected; a pulse signal transmit unit for generating a pulse signal and transmitting it to the subscriber line; a data acquisition unit for acquiring the pulse signal on the subscriber line and its echo wave and storing them to a storage unit; the storage unit for storing the data acquired by the data acquisition unit; control and calculation unit for controlling the pulse signal transmit unit and the data acquisition unit, and determining whether a bridged state is present or not according to the data acquired by the data acquisition unit. The solution realizes detection of a bridged state of a subscriber line, and it can locate the position of the bridge tap precisely, filling the blank of the technique for detecting a bridged state of a subscriber line.

Fig.3

**Description**

**Field of the Invention**

The present disclosure relates to the technical field of line detection, and in particular, to a device and a method for detecting the bridging state of a line.

**Background of the Invention**

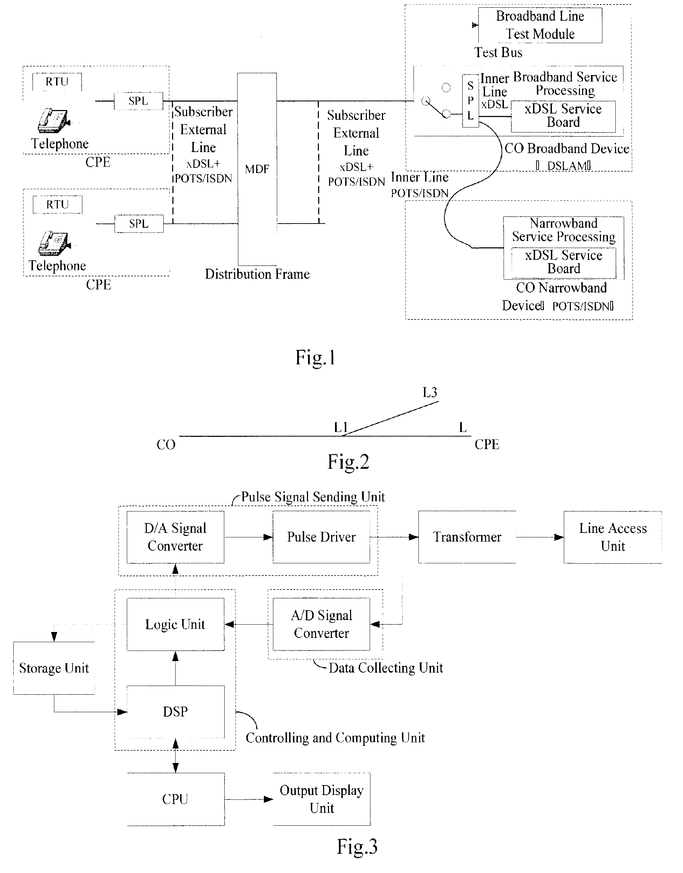

With the development of communication technologies, a broadband communication services, such as Asymmetric Digital Subscriber Line (ADSL), Very-high-speed Digital Subscriber Line (VDSL), etc., may be provided on a local cable that originally bears a narrowband communication service such as Plain Old Telephone Service (POTS)/ Integrated Service Digital Network (ISDN), etc. For example, such broadband communication services include ADSL over POTS, ADSL over ISDN, VDSL over POTS and VDSL over ISDN. For easy description, ADSL and VDSL will be called by a joint name ofxDSL.
As shown in Fig.1, xDSL signal and POTS/ISDN signal coexist in a subscriber external line. On the central office (CO) side, a SPLitter (SPL) in a broadband access device, Digital Subscriber Line Access Multiplexer (DSLAM), distinguishes a broadband service from a narrowband service, and respectively sends them to a broadband service board (xDSL service board) and a narrowband service board (POTS/ISDN service board) for processing; while on the Customer Premise Equipment (CPE) side, an SPL sends the separated broadband service and the narrowband service to a remote terminal unit (RTU) and a telephone set of the CPE.
During the operation and maintenance process of a broadband service, for example, when a subscriber reports a failure, it is often needed to perform various measurements on the subscriber line to determine the quality and failure status of the line and to determine whether the failure is reported by mistake. The broadband line test module in Fig.1 is adapted to implement various test functions.
In various failures, there is a failure called bridging, i.e., there is a branch in the line. The failure is as shown in Fig.2. Referring to Fig.2, it shows a line with a full length of L from a CO to a CPE, wherein a branch L3 exists in position L1. In such a case, the performance of a broadband service opened on the line will be influenced. But, at present, there exists no related technology for detecting subscriber line bridging.

**Summary of the Invention**

Accordingly, the embodiments of the disclosure provide a device for detecting the bridging state of a subscriber line. The embodiments of the disclosure further provide a method for detecting the bridging state of a subscriber line.
To attain the above objects, an embodiment of the invention provides a device for detecting the bridging state of a subscriber line, including:

    a line access unit, adapted to connect a subscriber line to be detected;
    a pulse signal sending unit, adapted to generate a pulse signal and send it to the subscriber line;
    a data collecting unit, adapted to collect the pulse signal and its echo on the subscriber line, and store them in a storage unit;
    a storage unit, adapted to store the data collected by the data collecting unit; and
    a controlling and computing unit, adapted to control the pulse signal sending unit and the data collecting unit, and determine whether a bridging state exists according to the data collected by the data collecting unit.

An embodiment of the invention further provides a method for detecting the bridging state of a subscriber line, including:

    sending a pulse signal to a subscriber line and sampling the signal on the subscriber line; and
    searching the sampled signal and determining whether a negative correlation echo exists, if there exists a negative correlation echo, a result is obtained that the bridging state exists.

It can be seen from the above technical solutions that, in the embodiments of the disclosure, by sending a time domain reflection (TDR) pulse signal to the subscriber line and detecting the pulse signal and its echo on the subscriber line at the same time, it is determined whether a bridging exists according to the echo status and the position of the bridging point is worked out. Thereby the bridging state of the subscriber line is detected, and the position where the bridging appears can be worked out accurately. Thereby the blank of related technology for detecting the bridging state of a subscriber line is filled up. By the implementation of the invention, it may also improve the service support level of the operator and reduce the cost of failure determination. Moreover, the embodiments of the disclosure further have the characteristics of high intelligentization degree and stable performance.

**Brief Description of the Drawings**

Fig.1 is a structural representation of a network in the prior art;

Fig.2 is a schematic diagram of the bridging state of a line in the prior art;

Fig.3 is a structural representation of a detection device according to an embodiment of the invention;

Fig.4 is a schematic diagram of a communication line according to an embodiment of the invention;

Fig.5 shows the time domain waveform observed on the sending end when a monopulse is transmitted on the transmission line according to an embodiment of the invention;

Fig.6 is a schematic diagram of a bridging in the communication line according to an embodiment of the invention;

Fig.7 is a schematic diagram of the time domain waveform when the length from the bridging point to the CPE is greater than the length of the bridging segment according to an embodiment of the invention;

Fig.8 is a schematic diagram of the time domain waveform when the length from the bridging point to the CPE is less than the length of the bridging segment according to an embodiment of the invention;

Fig.9 is a schematic diagram of the time domain waveform when the length from the bridging point to the CPE is equal to the length of the bridging segment according to an embodiment of the invention;

Fig.10 is a schematic diagram of the time domain waveform of a bridging test example according to an embodiment of the invention; and

Fig.1 is a schematic flow chart of an embodiment of the invention.

**Detailed Description of the Embodiments**

To make the objects, technical solutions and advantages of the invention more apparent, the disclosure will now be further illustrated in detail in conjunction with the embodiments.

Fig.3 is a structural representation of a bridging state detection device according to an embodiment of the invention;

Referring to Fig.3, the bridging state detection device includes a line access unit, a pulse signal sending unit, a data collecting unit, a storage unit and a controlling and computing unit. The bridging state detection device may further include a transformer, a CPU and an output display unit (Display).

The line access unit, which usually includes a relay matrix, is adapted to connect the bridging state detection device detection device with a subscriber line to be detected.

The pulse signal sending unit is mainly adapted to generate a TDR pulse signal according to the control by the controlling and computing unit, and send the pulse signal to the subscriber line via a line detection unit. The pulse signal sending unit may include a D/A signal converter and a pulse driver. The D/A signal converter converts a digital pulse signal into an analog voltage signal according to the control by the controlling and computing unit and sends the analog voltage signal to the pulse driver. The pulse driver amplifies the pulse signal and sends the amplified signal to the subscriber line.

The data collecting unit collects a signal from the subscriber line, including pulse signal and its echo, etc., then converts the collected analog voltage signal into a digital signal and sends the digital signal, via the controlling and computing unit, to the storage unit for saving. In addition, the data collecting unit may further perform adaptive gain adjustment; i.e., when the data collecting unit finds that the collected signal is too strong, it notifies the pulse signal sending unit via the controlling and computing unit to lower the gain of the pulse signal; when the data collecting unit finds that the collected signal is too weak, it notifies the pulse signal sending unit via the controlling and computing unit to improve the gain of the pulse signal. The data collecting unit may include an A/D signal converter.

The controlling and computing unit is mainly adapted to control the operation of the pulse signal sending unit and the data collecting unit, perform a related process according to the data obtained by the data collecting unit, determine whether a bridging state exists, and further compute the position of a bridging point when the bridging state exists. For example, it controls the pulse signal sending unit to start or stop the sending of a TDR pulse signal; controls the width of the pulse signal sent by the pulse signal sending unit; controls the data collection of the data collecting unit; and determines whether a bridging state exists according to the collected data; moreover, in the case that a bridging state exists, it computes the location of a bridging point, the length of line in the bridging segment and the full length of the line from the sending end to the CPE, etc., according to the collected data. It will be described below that how to determine and how to compute.

The controlling and computing unit may include a logic unit and a digital signal processing (DSP), wherein the logic unit is mainly adapted to control the pulse signal sending unit and the data collecting unit. The DSP is mainly adapted to implement data processing and computing. Additionally, the controlling and computing unit may only include a DSP, and the above functions are completely implemented by the DSP.

Data collected by the data collecting unit is saved in the storage unit in Fig.3, which may be a random access memory (RAM) or storage media of other forms.

The bridging state detection device shown in Fig.3 may further include a transformer, which amplifies a pulse signal sent by the pulse signal sending unit and sends the amplified signal to the subscriber line via the line access unit; at the same time, the transformer may further reduce the signal from the subscriber line.

The above detection device may further include a CPU and an output display unit. Wherein, the CPU is mainly adapted to control the operation of the whole device, especially the hardware-related process and the communication with the DSP. The output display unit displays the result of the controlling and computing unit, such as the waveform of the pulse signal and its echo, etc., to a subscriber.

The determination and computation method of the above detection device according to an embodiment of the disclosure will now be described.

When a signal is transmitted in a line, if the length of the line is comparable to the wavelength of the signal, the line and signal transmission process may be analyzed using transmission line theory. It might as well define the characteristic impedance at any point of the transmission line as:

$$Z_{c(x)} = \frac{U_{i(x)}}{I_{i(x)}} = \frac{U_{r(x)}}{I_{r(x)}}$$

In the above formula, $Z_{c(x)}$ represents the characteristic impedance at position x of the line; $U_{i(x)}$ represents the incident voltage at position x of the line; $I_{i(x)}$ represents the incident current at position x of the line; $U_{r(x)}$ represents the transmission voltage at position x of the line; and $I_{r(x)}$ represents the reflected current at position x of the line.

If the line is homogeneous, the characteristic impedance at any point of the line will be the same, and the signal will be transmitted along the line with no reflection; if the characteristic impedance at a certain point of the line changes, the signal will be reflected at this point; that is, a part of the signal will be transmitted back in the direction opposite to that of the original signal.

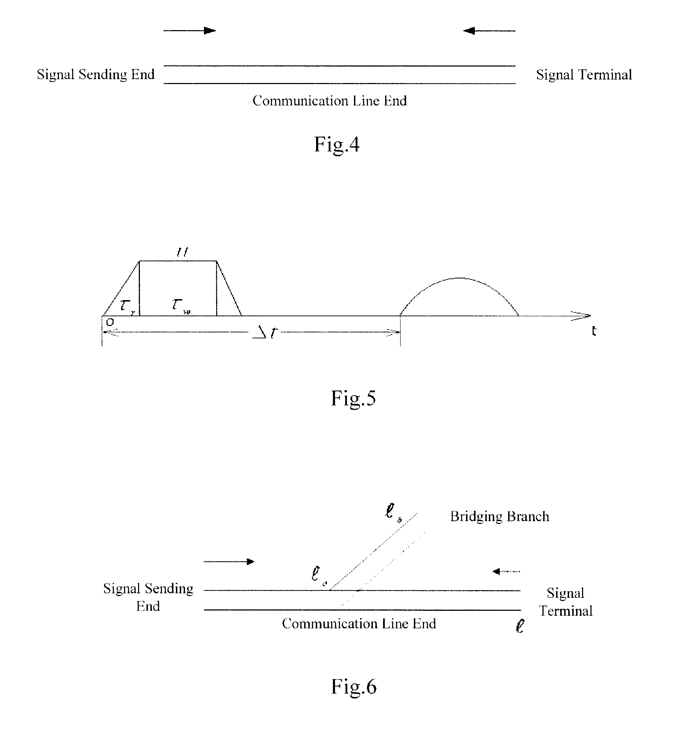

As shown in Fig.4, it is supposed that a very long communication line is open at one end, if a monopulse with a rising edge and a falling edge of $\tau_r$, a width of $\tau_w$ and an amplitude of $u$ is sent at a signal sending end to the communication line, and the signal voltage waveform is observed in real time at the sending end, it will be found that the waveform is as shown in Fig.5 in the case that only one reflection echo is drawn, wherein the time difference between the receiving of the echo and the sending of the pulse is $\Delta t$.

It might as well set the transmission speed of the signal in the line as $v$, thus the length of line may be computed as:

$$l = \frac{1}{2} v \Delta t \,.$$

Therefore, as shown in Fig.6, when a bridging segment with a length of $l_b$ exists at position $x = l_0$ of a line with a length of $l$, if a monopulse with a rising edge and a falling edge of $\tau_r$, a width of $\tau_w$ and an amplitude of $u$ is sent at a signal sending end to the line, and then the signal voltage waveform is observed in real time at the sending end, it will be found that the waveform may be as shown in the following cases when only one reflection echo is drawn:

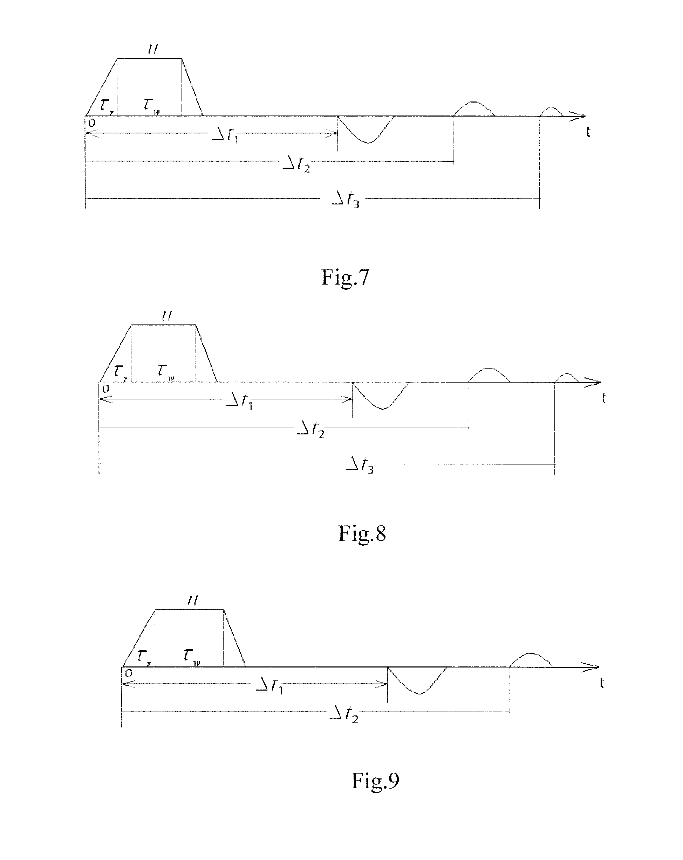

1) When $\ell - \ell_o > \ell_b$, the waveform observed is as shown in Fig.7. Wherein, the first echo is a negative correlation echo, which is an echo reflected back from the bridging point, and the time difference from the sending of the pulse wave is $\Delta t_1$; the second echo is a positive correlation echo, which is an echo reflected back from an end of the bridging segment, and the time difference from the sending of the pulse wave is $\Delta t_2$; the third echo is a positive correlation echo, which is an echo reflected back from the CPE, and the time difference from the sending of the pulse wave is $\Delta t_3$.

According to the above formula for computing the length of line, the distance between the bridging point and the sending end may be worked out; in other words, the location of a bridging point is:

$$\ell_o = \frac{1}{2}v\Delta t_1;$$

The full length of the line from the sending end to the CPE is:

$$\ell = \frac{1}{2}v\Delta t_3;$$

and
The length of line in the bridging segment is:

$$\ell_b = \frac{1}{2}v\left(\Delta t_2 - \Delta t_1\right).$$

2) When $\ell - \ell_o < \ell_b$, the waveform observed is as shown in Fig.8. Wherein, the first echo is a negative correlation echo, which is an echo reflected back from the bridging point, and the time difference from the sending of the pulse wave is $\Delta t_1$; the second echo is a positive correlation echo, which is an echo reflected back from the CPE, and the time difference from the sending of the pulse wave is $\Delta t_2$; the third echo is a positive correlation echo, which is an echo reflected back from an end of the bridging segment, and the time difference from the sending of the pulse wave is $\Delta t_3$.
Similarly, the location of the bridging point may be located as:

$$\ell_o = \frac{1}{2}v\Delta t_1;$$

The full length of the line from the sending end to the CPE is:

$$\ell = \frac{1}{2}v\Delta t_2;$$

and
The length of line in the bridging segment is:

$$\ell_b = \frac{1}{2}v\left(\Delta t_3 - \Delta t_1\right).$$

3) When $\ell - \ell_o = \ell_b$, the waveform observed is as shown in Fig.9. Wherein, the first echo is a negative correlation echo, which is an echo reflected back from the bridging point, and the time difference from the sending of the pulse wave is $\Delta t_1$; the second echo is a positive correlation echo, which is an overlap of an echo reflected back from the CPE and an echo reflected back from an end of the bridging segment, and the time difference from the sending of the pulse wave is $\Delta t_2$.

Then, the location of the bridging point may be located as:

$$\ell_o = \frac{1}{2} v \Delta t_1 ;$$

The full length of the line from the sending end to the CPE is:

$$\ell = \frac{1}{2} v \Delta t_2 ;$$

and

The length of line in the bridging segment is:

$$\ell_b = \frac{1}{2} v \left( \Delta t_2 - \Delta t_1 \right).$$

In addition, the longer the line is, the larger the attenuation of the signal will be; and the higher the frequency of the pulse is, the larger the attenuation of transmission in the line will be. Different pulse signals include different frequency components, and therefore the length of line that can be detected by specific pulse signal waveform is different. When the line is short, it is suitable to employ a narrow pulse, so that identification precision may be improved and blind zone may be reduced; when length of line is long, it is suitable to employ a broad pulse, so that distance of identification may be improved.

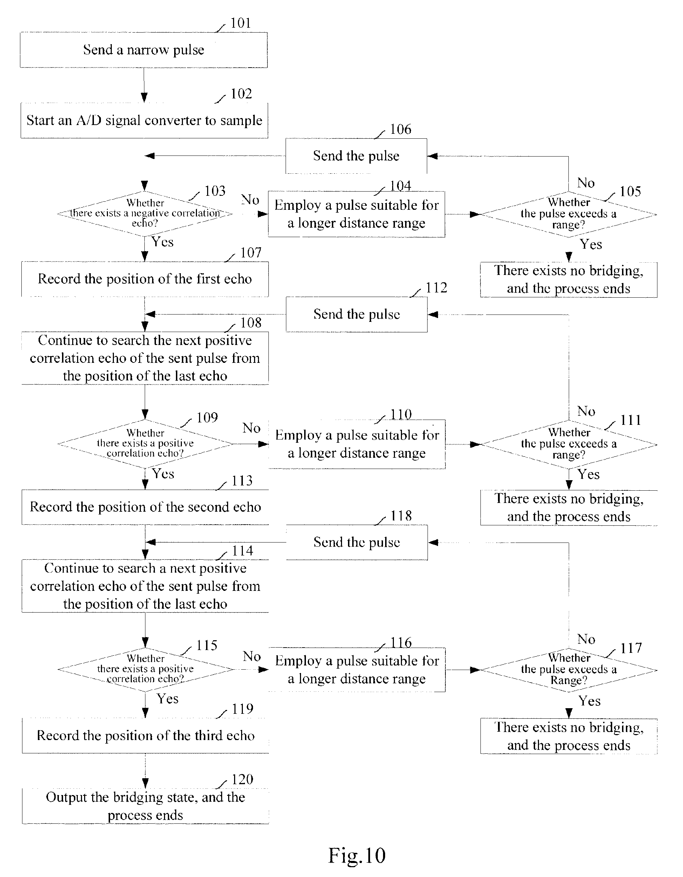

Fig.10 shows a detection process according to an embodiment of the disclosure. Referring to Fig.10, the process includes the following steps.

Step 101 to Step 102: A CPU issues a test command to a DSP; after the DSP obtains the command, it sends the related parameter configuration to a logic unit; then, the logic unit starts a D/A signal converter to generate a TDR pulse waveform, and the pulse waveform will be amplified by a transformer after driven by a pulse driver, then the amplified pulse waveform is sent to a subscriber line. On the other hand, the logic unit also starts an A/D signal converter to sample the line voltage at the same time when the D/A signal converter is started, and the sampled data is saved in an RAM.

In addition, because the range of the line length is unknown when the test is started, it is detected firstly a line which is greater than the shortest distance of the blind zone of the system test, and the pulse width will be increased when it is not suitable.

Step 103: The DSP searches the sampled voltage waveform, and determines whether there exists an echo of which the polarity is opposite to the sent pulse signal, i.e., whether there exists a negative correlation echo, if there exists a negative correlation echo, the process proceeds to Step 107 and its subsequent steps; otherwise, the process proceeds to Step 104 and its subsequent steps.

Step 104: The pulse parameter is adjusted, and a pulse suitable for a longer distance range is employed, that is, a broader pulse is employed.

Step 105: It is determined whether the width of the employed pulse exceeds a preset width range, if not, the process proceeds to Step 106, that is, it sends the adjusted pulse to the subscriber line; otherwise, a result is obtained that there exists no bridging and the process is ended.

Here, the pulse exceeding a certain width range is corresponding to that the searching of the subscriber line exceeds a certain length range.

Step 107: The position of the first echo, i.e., the negative correlation echo, is recorded. The position may be a time difference relative to the sending of the pulse, or it may be a distance computed via formula

$$l_o = \frac{1}{2} v \Delta t_1$$

.

Here, it takes the time difference as an example.

Here the DSP may obtain a result that a bridging state exists in the subscriber line, and the location of the bridging point may be worked out according to the time difference between the receiving of the negative correlation echo and the sending of the pulse signal and the formula

$$l_o = \frac{1}{2} v \Delta t_1$$

.

Step 108 to Step 109: Continuing to search from the position of the first echo whether there is an echo which has the same polarity as the sent pulse, i.e., a positive correlation echo, after the first echo. If there exists a positive correlation echo, the process proceeds to Step 113 and its subsequent steps; otherwise, the process proceeds to Step 110 and its subsequent steps.

Step 110: The pulse parameter is adjusted, and a pulse suitable for a longer distance range is employed, that is, a broader pulse is employed.

Step 111: It is determined whether the employed pulse exceeds a preset width range, if not, the process returns to Step 112; otherwise, a result is obtained that there exists no bridging and the process is ended.

Step 112: The adjusted pulse is sent to the subscriber line, and then the process proceeds to Step 108 and the subsequent steps.

However, the process may also proceeds to Step 103 and its subsequent steps after Step 112; but, this may cause the repeated detection of the negative correlation echo, and system resources may be wasted.

Step 113: The position of the second echo, i.e., the positive correlation echo, is recorded. Then, the DSP computes the length of line in the bridging segment according to the time difference between the receiving of the second echo and the receiving of the first echo and the formula

$$\ell_b = \frac{1}{2} v \left( \Delta t_2 - \Delta t_1 \right) = \frac{1}{2} v \Delta t_2 - \frac{1}{2} v \Delta t_1$$

.

Step 114 to Step 115: Continuing to search from the position of the second echo whether there exists another echo with the same polarity as the pulse sent, i.e., a positive correlation echo, if there exists a positive correlation echo, the process proceeds to Step 119 and its subsequent steps; otherwise, the process proceeds to Step 116 and its subsequent steps.

Step 116: The pulse parameter is adjusted, and a pulse suitable for a longer distance range is employed, that is, a broader pulse is employed.

Step 117: It is determined whether the employed pulse exceeds a preset width range, if not, the process returns to Step 118; otherwise, a result is obtained that there exists no bridging and the process is ended.

Step 118: The adjusted pulse is sent to the subscriber line, and then the process proceeds to Step 114 and the subsequent steps.

However, after Step 118, the process may also proceeds to Step 103 and its subsequent steps; but this may similarly cause the repeated detection of the negative correlation echo, and system resources may be wasted.

Step 119: The position of the third echo, i.e., the positive correlation echo, is recorded. Then, the DSP may compute the full length of the line from the sending end to the CPE according to time difference between the receiving of the third echo and the sending of the pulse signal and the formula

$$\ell = \frac{1}{2} v \Delta t_3.$$

Step 120: The DSP outputs a result that a bridging state exists in the subscriber line, and the position of a bridging point, via an output display unit. Moreover, it may further output the length of line in the bridging segment and the full length of the line from the sending end to the CPE. In addition, to display more detailed information to the subscriber, an obtained voltage oscillogram may be further displayed on the output display unit. Then, the process is ended.

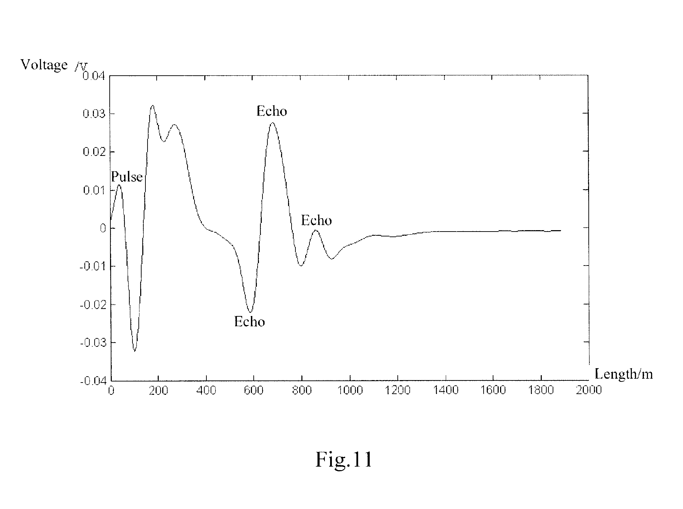

Fig.11 shows a schematic diagram of the voltage waveform in the case that a bridging exists in a practical line. In Fig.11, the abscissa has been converted into unit of length.

In the subscriber line to be detected, each parameter is as follows:

$$\begin{cases} \ell_o = 500m \\ \ell = 800m \\ \ell_b = 200m \end{cases}$$

By a detection which is carried out by using the method according to the embodiments of the invention, a result is obtained as shown in Fig.11, so that a conclusion is drawn that there exists a bridging point; moreover, it can be seen from Fig.11 that each value measured is as follows:

$$\begin{cases} \ell_o = 505m \\ \ell = 812m \\ \ell_b = 199m \end{cases}$$

It can be seen, by comparing the measuring result with the parameters of the line, that the embodiments of the invention have a higher accuracy.

The above descriptions are merely illustrative of the preferred embodiments of the invention but not limitative to the scope of the invention. Any modifications, alternatives and adaptations made without departing from the spirit of the invention shall come into the scope of the invention as defined in the appended claims.

**Claims**

1. A device for detecting a bridging state of a subscriber line, comprising:

    a line access unit, adapted to connect a subscriber line to be detected;
    a pulse signal sending unit, adapted to generate a pulse signal and send it to the subscriber line;
    a data collecting unit, adapted to collect the pulse signal and its echo on the subscriber line, and store them in a storage unit;
    a storage unit, adapted to store the data collected by the data collecting unit; and
    a controlling and computing unit, adapted to control the pulse signal sending unit and the data collecting unit, and determine whether a bridging state exists according to the data collected by the data collecting unit.

2. The device according to claim 1, wherein, the pulse signal sending unit comprises:

    a D/A signal converter, adapted to generate a pulse signal according to the control by the controlling and computing unit; and
    a pulse driver, adapted to amplify the pulse signal and send it to the subscriber line.

**3.** The device according to claim 1, further comprising:

a transformer, adapted to amplify the signal from the pulse signal sending unit and reducing the signal from the subscriber line.

**4.** The device according to claim 1, wherein, the data collecting unit comprises:

an A/D signal converter, adapted to collect the pulse signal and its echo on the subscriber line and store them in the storage unit.

**5.** The device according to claim 1, wherein, the controlling and computing unit comprises:

a Digital Signal Processing, DSP, adapted to control the pulse signal sending unit and the data collecting unit, and determine whether a bridging state exists according to the data collected by the data collecting unit.

**6.** The device according to claim 1, wherein, the controlling and computing unit comprises:

a logic unit, adapted to control the pulse signal sending unit and the data collecting unit; and
a DSP, adapted to determine whether a bridging state exists according to the data collected by the data collecting unit.

**7.** The device according to claim 1, wherein, the controlling and computing unit is further adapted to compute the position of a bridging point when the bridging state exists.

**8.** The device according to claim 7, wherein, the controlling and computing unit comprises:

a DSP, adapted to control the pulse signal sending unit and the data collecting unit and determine whether a bridging state exists according to the data collected by the data collecting unit, and compute the position of a bridging point when the bridging state exists.

**9.** The device according to claim 7, wherein, the controlling and computing unit comprises:

a logic unit, adapted to control the pulse signal sending unit and the data collecting unit; and
a DSP, adapted to determine whether a bridging state exists according to the data collected by the data collecting unit, and compute the position of a bridging point when the bridging state exists.

**10.** The device according to claim 1, further comprising:

an output display unit, adapted to display the result of the controlling and computing unit.

**11.** A method for detecting a bridging state of a subscriber line, comprising:

sending a pulse signal to a subscriber line and sampling the signal on the subscriber line; and
searching the sampled signal and determining whether a negative correlation echo exists; and obtaining a result that the bridging state exists, if a negative correlation echo exists.

**12.** The method according to claim 11, further comprising:

adjusting the width of the pulse signal, sending a pulse signal to the subscriber line and performing the sampling and its subsequent process, if a negative correlation echo does not exist.

**13.** The method according to claim 12, after adjusting the width of the pulse signal, further comprising:

determining whether the width exceeds a preset width range; and obtaining a result that there does not exist a bridging state, if the width exceeds a preset width range; or sending pulse information to the subscriber line and performing a sampling and its subsequent process, if the width does not exceed a preset width range.

**14.** The method according to claim 11, further comprising:

searching the sampled signal and determining whether there exists a positive correlation echo after the negative correlation echo; computing the length of line in the bridging segment according to the time difference between the receiving of the positive correlation echo and the receiving of the negative correlation echo, if there exists a positive correlation echo after the negative correlation echo.

15. The method according to claim 14, further comprising:

searching the sampled signal and determining whether there exists another positive correlation echo after the positive correlation echo; computing the length of line from the sending end to the Customer Premise Equipment, CPE, according to the time difference between the receiving of the another positive correlation echo and the sending of the pulse signal if there exists another positive correlation echo after the positive correlation echo.

16. The method according to claim 11, further comprising:

searching the sampled signal and determining whether there exists a positive correlation echo after the negative correlation echo, computing the length of line from the sending end to the CPE according to the time difference between the receiving of the positive correlation echo and the sending of the pulse signal if there exists a positive correlation echo after the negative correlation echo.

17. The method according to claim 16, further comprising:

searching the sampled signal and determining whether another positive correlation echo exists after the positive correlation echo, computing the length of line in the bridging segment according to the time difference between the receiving of the another positive correlation echo and the receiving of the negative correlation echo, if there exists a positive correlation echo after the positive correlation echo.

18. The method according to claim 11, further comprising:

searching the sampled signal and determining whether there exists a positive correlation echo after the negative correlation echo; if there exists a positive correlation echo after the negative correlation echo, computing the length of line from the sending end to the CPE according to the time difference between the receiving of the positive correlation echo and the sending of the pulse signal, and computing the length of line in the bridging segment according to the time difference between the receiving of the positive correlation echo and the receiving of the negative correlation echo.

19. The method according to any one of claims 14 to 18, further comprising:

adjusting the width of the pulse signal, sending a pulse signal to the subscriber line and performing the sampling and its subsequent process if there does not exist a positive correlation echo; or
adjusting the width of the pulse signal, sending the pulse signal to the subscriber line, sampling the signal on the subscriber line and searching the sampled signal if there does not exist a positive correlation echo; and determining whether there exists a positive correlation echo after the negative correlation echo, performing the computation if there exists a positive correlation echo.

20. The method according to claim 15 or 17, further comprising:

adjusting the width of the pulse signal, sending a pulse signal to the subscriber line and performing the sampling and its subsequent process, if there does not exist the another positive correlation echo; or
adjusting the width of the pulse signal, sending the pulse signal to the subscriber line, sampling the signal on the subscriber line and searching the sampled signal, if there does not exist the another positive correlation echo; and determining whether another positive correlation echo exists after the positive correlation echo, performing the computation process if there exists a positive correlation echo.

RTU

SPL

Telephone
CPE

RTU

SPL

Telephone
CPE

Subscriber
External
Line
xDSL+
POTS/ISDN

MDF

Distribution Frame

Subscriber
External
Line
xDSL+
POTS/ISDN

Broadband Line
Test Module

Test Bus

Inner Broadband Service
Line Processing
xDSL
S
P
L

xDSL Service
Board

CO Broadband Device
〔 DSLAM〕

Inner Line
POTS/ISDN

Narrowband
Service Processing

xDSL Service
Board

CO Narrowband
Device〔 POTS/ISDN〕

Fig.1

L3

L1                                    L

CO                                    CPE

Fig.2

Pulse Signal Sending Unit

D/A Signal
Converter

Pulse Driver

Transformer

Line Access
Unit

Logic Unit

A/D Signal
Converter

Storage Unit

Data Collecting Unit

DSP

Controlling and Computing Unit

CPU

Output Display
Unit

Fig.3

Signal Sending End

Communication Line End

Signal Terminal

Fig.4

$t$ $t$

$\tau_r$ $\tau_w$

$O$

$\Delta t$

$t$

Fig.5

$\ell_b$

Bridging Branch

$\ell_o$

Signal Sending End

Communication Line End

$\ell$

Signal Terminal

Fig.6

Fig.7

Fig.8

Fig.9

Send a narrow pulse — 101

Start an A/D signal converter to sample — 102

Send the pulse — 106

Whether there exists a negative correlation echo? — 103 | No → Employ a pulse suitable for a longer distance range — 104 | → Whether the pulse exceeds a range? — 105 | No

Yes

Whether the pulse exceeds a range? — 105 | Yes → There exists no bridging, and the process ends

Record the position of the first echo — 107

Send the pulse — 112

Continue to search the next positive correlation echo of the sent pulse from the position of the last echo — 108

Whether there exists a positive correlation echo? — 109 | No → Employ a pulse suitable for a longer distance range — 110 | → Whether the pulse exceeds a range? — 111 | No

Yes

Whether the pulse exceeds a range? — 111 | Yes → There exists no bridging, and the process ends

Record the position of the second echo — 113

Send the pulse — 118

Continue to search a next positive correlation echo of the sent pulse from the position of the last echo — 114

Whether there exists a positive correlation echo? — 115 | No → Employ a pulse suitable for a longer distance range — 116 | → Whether the pulse exceeds a Range? — 117 | No

Yes

Whether the pulse exceeds a Range? — 117 | Yes → There exists no bridging, and the process ends

Record the position of the third echo — 119

Output the bridging state, and the process ends — 120

Fig.10

14

Fig.11

<div align="center">

**INTERNATIONAL SEARCH REPORT**

</div>

| | |
|---|---|
| | International application No. |
| | PCT/CN2007/070286 |

**A. CLASSIFICATION OF SUBJECT MATTER**

<div align="center">

H04L12/26(2006.01)i

</div>

According to International Patent Classification (IPC) or to both national classification and IPC

**B. FIELDS SEARCHED**

Minimum documentation searched (classification system followed by classification symbols)

<div align="center">

IPC: H04L12/26   H04L G01R H04B

</div>

Documentation searched other than minimum documentation to the extent that such documents are included in the fields searched

Electronic data base consulted during the international search (name of data base and, where practicable, search terms used)

<div align="center">

WPI, EPODOC, PAJ, CPRS, CNKI: line? bridg+ pulse impulse echo reflect+ tdr check+ detect+ monitor+ test+

</div>

**C. DOCUMENTS CONSIDERED TO BE RELEVANT**

| Category* | Citation of document, with indication, where appropriate, of the relevant passages | Relevant to claim No. |
|---|---|---|
| X | WO 02078239 A2 (CONEXANT SYSTEMS, INC) 3 Oct. 2002(03.10.2002) figures 2A, 2B, 4, 12, description page 14 line 17 - page 15 line 19, page 17 line 7 - 16, page 18 line 7 - page 19 line 1, page 24 line 5 – page 25 line 10, page 35 line 5 - page 36 line 4, page 38 line 10-16, page 40 line 17-22, page 42 line 15-18, page 45 line 15 – page 47 line 17 | 1-11, 14-18 |
| Y | | 12-13, 19-20 |
| Y | US 6862546 B2 (INTEL CORPORATION) 1 Mar. 2005(01.03.2005) figures 4-8 and claims 1-12 | 12-13, 19-20 |
| A | US 6959037 B2 (SPIRENT COMMUNICATIONS OF ROCKVILLE, INC.) 25 Oct. 2005(25.10.2005) the whole document | 1-20 |

☐ Further documents are listed in the continuation of Box C.          ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
|---|---|
| 29 Sep. 2007(29.09.2007) | **25 Oct. 2007 (25.10.2007)** |
| Name and mailing address of the ISA/CN<br>The State Intellectual Property Office, the P.R.China<br>6 Xitucheng Rd., Jimen Bridge, Haidian District, Beijing, China<br>100088<br>Facsimile No. 86-10-62019451 | Authorized officer<br><br>DONG, Jie<br><br>Telephone No. (86-10)62084984 |

Form PCT/ISA/210 (second sheet) (April 2007)

INTERNATIONAL SEARCH REPORT
Information on patent family members

International application No.

PCT/CN2007/070286

| Patent Documents referred in the Report | Publication Date | Patent Family | Publication Date |
|---|---|---|---|
| WO 02078239 A2 | 03 Oct. 2002(03.10.2002) | US 2002161539 A1 | 31 Oct. 2002(31.10.2002) |
| | | US 2002161542 A1 | 31 Oct.2002(31.10.2002) |
| | | US 6934655 B2 | 23 Aug. 2005(23.08.2005) |
| | | US 2002169585 A1 | 14 Nov. 2002(14.11.2002) |
| | | US 6697768 B2 | 24 Feb. 2004(24.02.2004) |
| | | EP 1377843 A2 | 07 Jan. 2004(07.01.2004) |
| | | US 2004019443 A1 | 29 Jan. 2004(29.01.2004) |
| | | US 6885954 B2 | 26 Apr. 2005(26.04.2005) |
| | | US 2004044489 A1 | 04 Mar. 2004(04.03.2004) |
| | | US 6947857 B2 | 20 Sep. 2005(20.09.2005) |
| | | AU 2002306720 A1 | 13 Oct. 2005(13.10.2005) |
| US 6862546 B2 | 01 Mar. 2005(01.03.2005) | US 2003163272 A1 | 28 Aug. 2003(28.08.2003) |
| | | WO 03073113 A1 | 04 Sep. 2003(04.09.2003) |
| | | CN 1450354 A | 22 Oct. 2003(22.10.2003) |
| | | AU 2003217341 A1 | 09 Sep. 2003(09.09.2003) |
| US 6959037 B2 | 25 Oct. 2005(25.10.2005) | US 2005057880 B2 | 17 Mar. 2005(17.03.2005) |
| | | WO 2005029747 A2 | 31 Mar. 2005(31.03.2005) |

Form PCT/ISA/210 (patent family annex) (April 2007)